(19) Europäisches Patentamt / European Patent Office / Office européen des brevets

(11) **EP 2 894 445 A1**

(12) **DEMANDE DE BREVET EUROPEEN**

(43) Date de publication:
**15.07.2015 Bulletin 2015/29**

(51) Int Cl.:
*G01J 5/22* (2006.01)

(21) Numéro de dépôt: **14200594.1**

(22) Date de dépôt: **30.12.2014**

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**
Etats d'extension désignés:
**BA ME**

(30) Priorité: **08.01.2014 FR 1400025**

(71) Demandeur: **Commissariat à l'Énergie Atomique et aux Énergies Alternatives 75015 Paris (FR)**

(72) Inventeurs:
• **Becker, Sébastien**
  **38500 VOIRON (FR)**
• **Hamelin, Antoine**
  **38000 GRENOBLE (FR)**

(74) Mandataire: **Brevalex**
  **95, rue d'Amsterdam**
  **75378 Paris Cedex 8 (FR)**

(54) **Dispositif et procédé de détection infrarouge**

(57)   Dispositif de détection infrarouge (100) comportant au moins un premier bolomètre (106) apte à détecter au moins une partie d'un rayonnement infrarouge destiné à être reçu par le dispositif de détection infrarouge, et un circuit de lecture et de compensation (110) d'un premier signal électrique destiné à être délivré par le premier bolomètre, le circuit de lecture et de compensation comprenant au moins :
- un deuxième bolomètre (112) couplé électriquement au premier bolomètre et insensible au rayonnement infrarouge destiné à être reçu par le dispositif de détection infrarouge ;
- des premiers moyens (116, 118, 120) de lecture dudit premier signal électrique auquel est soustrait un deuxième signal électrique destiné à être délivré par le deuxième bolomètre ;
- des deuxièmes moyens (109, 212.1 - 212.3) de lecture d'une tension électrique aux bornes du premier bolomètre et/ou d'une tension électrique aux bornes du deuxième bolomètre, comportant une pluralité d'interrupteurs.

FIG.3

EP 2 894 445 A1

**Description**

**DOMAINE TECHNIQUE**

L'invention concerne un dispositif de détection, ou d'imagerie infrarouge, à base de bolomètres et comprenant un circuit de lecture de pixels apte à compenser des perturbations thermiques subis par les pixels et permettant de caractériser électriquement au moins un bolomètre sensible du circuit de lecture.

**ART ANTÉRIEUR**

Un dispositif de détection infrarouge bolométrique est un dispositif capable de fonctionner à température ambiante, et comportant une matrice de pixels dans laquelle chaque pixel comporte un bolomètre. Chaque bolomètre comporte un matériau dont la résistivité électrique varie en fonction d'un échauffement provoqué par un rayonnement infrarouge incident. Les variations de la résistivité électrique du matériau sensible à la température des bolomètres sont mesurées via les variations de courant induites par l'exposition des bolomètres à une scène, la polarisation aux bornes du bolomètre étant fixe. Ces variations de courant sont directement proportionnelles aux variations des résistances électriques des bolomètres, et sont elles-mêmes liées aux variations de température subies par le matériau sensible des bolomètres lorsqu'ils sont exposés à la lumière issue de la scène observée.

Toutefois, la très faible variation relative de la résistance électrique des bolomètres lors de l'observation d'une scène rend la mesure des variations locales de température de cette scène très délicate par de tels bolomètres. Pour s'affranchir de la majeure partie du signal inutile, des bolomètres dits « de compensation », ou « d'ébasage », ou « de référence » sont généralement utilisés. Ces bolomètres sont insensibles au flux optique incident reçu par les bolomètres des pixels et issu de la scène observée. Ils sont classiquement thermiquement liés au substrat ou ils peuvent également être écrantés mécaniquement. Le circuit de lecture permettant la lecture des courants délivrés par les bolomètres des pixels est dans ce cas conçu tel que les courants générés à travers les bolomètres de compensation soient soustraits des courants issus des bolomètres sensibles au flux optique incident. De cette manière, l'essentiel du courant de mode commun est éliminé lors de la lecture des courants délivrés par les bolomètres sensibles au flux optique incident. Une telle configuration est par exemple décrite dans le document EP 2 208 976 A1.

D'autre part, les fluctuations de la température du substrat produisent un signal inutile défavorable à la détection du signal utile issu de la scène observée et que l'on cherche à mesurer. Pour limiter cet effet, le substrat est généralement régulé thermiquement.

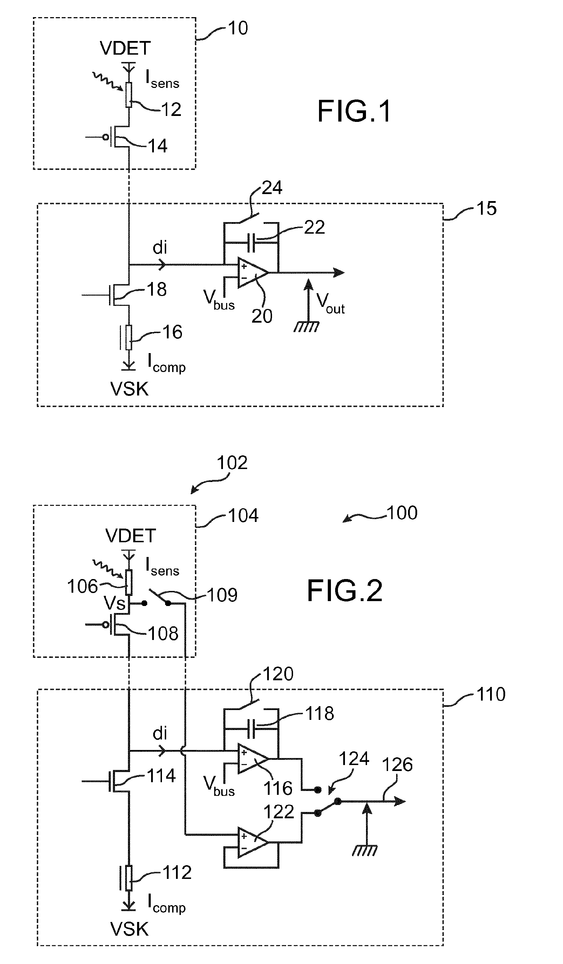

De telles structures de compensation sont généralement positionnées dans chaque pied de colonne de la matrice de pixels, comme représenté sur la figure 1. Sur cette figure, un pixel 10 d'une matrice de pixels d'un dispositif de détection infrarouge est représenté et comporte un bolomètre 12 sensible à un flux optique reçu par la matrice de pixels et relié d'un côté à un premier potentiel électrique VDET d'une tension d'alimentation et de l'autre à la source d'un premier transistor MOS d'injection 14, ici de type PMOS. Les pixels de la colonne de la matrice à laquelle appartient le pixel 10 sont tous reliés au même circuit de lecture et de compensation 15 comprenant un bolomètre de compensation 16 relié d'un côté à un deuxième potentiel électrique VSK de la tension d'alimentation et de l'autre à la source d'un deuxième transistor MOS d'injection 18, ici de type NMOS.

En variante, il peut y avoir plusieurs pixels de compensation par colonne montés en série et/ou en parallèle les uns par rapport aux autres. Il est également possible d'avoir un bolomètre de référence disposé en tête de chaque ligne de la matrice de pixels à la place du bolomètre de compensation disposé en pied de colonne. Dans ce cas, par un jeu de miroirs de courant, le courant circulant dans le bolomètre de référence est recopié et soustrait des courants issus des bolomètres sensibles au flux optique incident.

La lecture de l'information délivrée par les bolomètres des pixels de la matrice se faisant séquentiellement ligne par ligne en connectant successivement les bolomètres des pixels au circuit de lecture et de compensation associé, au fur et à mesure de la lecture des différentes lignes, chaque bolomètre sensible au flux optique incident est donc compensé par le même bolomètre de compensation associé à la colonne à laquelle appartient le bolomètre lu. Un courant utile $di = I_{sens} - I_{comp}$, avec $I_{sens}$ correspondant au courant traversant le bolomètre 12 et $I_{comp}$ correspondant au courant de compensation traversant le bolomètre de compensation 16, est intégré dans une capacité 22 couplée à un amplificateur opérationnel 20 monté en intégrateur, et formant un amplificateur à transimpédance et condensateur (CTIA), se trouvant également en pied de colonne, dans le circuit de lecture et de compensation 15, pendant un temps d'intégration T déterminé. La sortie de l'amplificateur 20 est rebouclée sur l'entrée non inverseuse de l'amplificateur opérationnel 20 via la capacité 22. Un interrupteur 24 relié en parallèle à la capacité 22 permet de réinitialiser la capacité 22 lors de la lecture de l'information fournie par le pixel de la ligne précédente. Une tension de polarisation $V_{bus}$ de l'amplificateur opérationnel 20 est appliquée sur son entrée inverseuse.

Lors de la mise en route du circuit de la figure 1, les tensions de polarisation appliquées sur les grilles des transistors MOS 14 et 18 sont généralement choisies pour qu'en présence d'une scène uniforme (par exemple lorsque l'on obture optiquement le système), le courant utile *di* soit sensiblement nul pour l'ensemble des pixels de la matrice, c'est-à-dire tel que le courant $I_{sens}$ soit sensiblement égal au courant $I_{comp}$. La performance du détecteur (réponse et bruit temporel, etc.) étant dépendante du courant circulant dans le bolomètre sensible ($I_{sens}$), la polarisation du pont bolométrique (formé du bolomètre sensible, du bolomètre de compensation associé et des transistors MOS associés à ces deux bolomètres), c'est-à-dire les tensions de polarisation appliquées sur les grilles des transistors MOS 14 et 18, est choisie pour obtenir une performance nominale.

En effet, jusqu'à une certaine valeur du courant de polarisation, la performance du détecteur, exprimée par le NETD (« Noise Equivalent Temperature Différence », ou rapport entre le bruit temporel et la réponse du détecteur) s'améliore. Ce phénomène provient du fait que la réponse du détecteur s'améliore plus rapidement que le bruit. Passé cette valeur, le bruit et la réponse évoluent de manière symétrique, et il n'y a donc plus de gain en termes de performance. Si le courant de polarisation augmente encore, la performance devient limitée par le circuit de lecture, et notamment le CTIA, qui devient lui-même une source de bruit. La performance se dégrade alors. L'objectif est donc de placer le détecteur dans la configuration où sa performance est nominale, c'est-à-dire sur le plateau où le bruit et la réponse évoluent symétriquement.

D'autre part, la connaissance précise du courant circulant dans les bolomètres sensibles a une importance pour simuler les performances des détecteurs car c'est un paramètre d'entrée des modèles numériques. Ce paramètre est habituellement difficilement accessible car il dépend notamment de la variabilité technologique des tensions de seuil des transistors MOS utilisés. Les performances du pixel telles que le bruit temporel et la réponse par exemple, peuvent être simulées numériquement à partir des paramètres technologiques du pixel comme le design, les paramètres matériaux (tels que le coefficient Kf de bruit en 1/f, le coefficient TCR de variation thermique de la résistance du bolomètre, etc...) ; auxquels il convient d'ajouter le courant circulant dans le bolomètre sensible ($I_{sens}$). Ce courant est généralement estimé en mesurant la consommation de l'alimentation électrique qui alimente tous les bolomètres de la matrice, et en divisant cette consommation électrique mesurée par le nombre de colonnes de pixels que comporte la matrice de pixels. Cette méthode pose toutefois un problème lorsque la matrice possède plusieurs pixels défectueux car dans ce cas, la consommation de cette alimentation électrique peut être impactée par ces défauts (typiquement des court-circuits et des circuits ouverts). De plus, cette méthode de mesure du courant ne peut pas s'appliquer lorsque l'alimentation électrique est utilisée pour alimenter électriquement d'autres composants en plus des ponts bolométriques car dans ce cas, la consommation électrique de cette alimentation n'est plus intégralement imputable aux ponts bolométriques.

D'autre part, du point de vue de l'intégration technologique, il est également important de connaître avec précision la valeur des résistances électriques des bolomètres sensibles et leur dispersion. Classiquement, la résistance du bolomètre sensible 12, appelée $R_{sens}$, est mesurée en mettant le premier transistor MOS d'injection 14 en régime ohmique et le deuxième transistor MOS d'injection 18 à l'état bloqué ($I_{comp}$ = 0). Les valeurs du courant intégré par l'amplificateur opérationnel 20 (respectivement appelées $I_1$ et $I_2$, et correspondant aux valeurs des courants traversant le bolomètre sensible 12 et le premier transistor MOS d'injection 14) pour deux valeurs de VDET (appelées respectivement VDET$_1$ et VDET$_2$) proches de la tension de polarisation $V_{bus}$ de l'amplificateur opérationnel 20 sont ensuite mesurées. On obtient alors pour les deux mesures :

$$R_{sens} + r_{MOS} = \frac{VDET_1 - V_{bus}}{I_1} = \frac{VDET_2 - V_{bus}}{I_2}$$

$$R_{sens} \gg r_{MOS}$$

$$I_1 = \frac{C}{T}(V_{out1} - V_{bus})$$

$$I_2 = \frac{C}{T}(V_{out2} - V_{bus})$$

(1)

avec $r_{MOS}$ : résistance électrique du premier transistor MOS d'injection 14 en régime ohmique ;
$V_{out1}$ et $V_{out2}$ : tensions obtenues en sortie de l'amplificateur opérationnel 20 respectivement pour les courants $I_1$ et $I_2$;
C : valeur de la capacité électrique 22.

La valeur de la résistance $R_{sens}$ du bolomètre sensible 12 peut donc être estimée selon l'équation :

$$R_{sens} \approx \frac{T}{C} \times \frac{VDET_2 - VDET_1}{V_{out1} - V_{out2}}$$

(2)

Une méthode similaire utilisant une seule valeur de VDET et deux temps d'intégration distincts permet également de mesurer $R_{sens}$.

Toutefois, cette méthode d'estimation de $R_{sens}$ n'est pas toujours applicable, notamment lorsque le potentiel électrique VDET ne peut pas être modifié ou lorsqu'il est difficile de mettre en oeuvre cette méthode avec deux temps d'intégration distincts.

## EXPOSÉ DE L'INVENTION

Un but de la présente invention est de proposer un dispositif de détection infrarouge, ainsi qu'un procédé de détection, comportant une structure de compensation et permettant en outre de calculer la résistance électrique d'un bolomètre sensible et/ou d'un bolomètre de compensation ainsi que le courant circulant dans chaque pont bolométrique du dispositif de détection indépendamment les uns des autres et indépendamment de l'alimentation électrique du dispositif.

Pour cela, la présente invention propose un dispositif de détection infrarouge comportant au moins un premier bolomètre apte à détecter au moins une partie d'un rayonnement infrarouge destiné à être reçu par le dispositif de détection infrarouge, et un circuit de lecture et de compensation d'un premier signal électrique destiné à être délivré par le premier bolomètre, le circuit de lecture et de compensation comprenant au moins :

- un deuxième bolomètre couplé électriquement au premier bolomètre et insensible au rayonnement infrarouge destiné à être reçu par le dispositif de détection infrarouge ;
- des premiers moyens de lecture dudit premier signal électrique auquel est soustrait un deuxième signal électrique destiné à être délivré par le deuxième bolomètre ;
- des deuxièmes moyens de lecture d'une tension électrique aux bornes du premier bolomètre et/ou d'une tension électrique aux bornes du deuxième bolomètre.

Ainsi, l'intégration de deuxièmes moyens de lecture de la tension électrique aux bornes du premier bolomètre au sein du circuit de lecture et de compensation permet de calculer, à partir de la mesure de cette tension, la résistance électrique du premier bolomètre sensible. Moyennant la connaissance de la valeur de la ou des résistances électriques des bolomètres sensibles, le dispositif de détection infrarouge selon l'invention permet également de connaître le courant circulant dans le bolomètre sensible ou chacun des bolomètres sensibles du dispositif de détection indépendamment les uns des autres. De plus, l'intégration de deuxièmes moyens de lecture de la tension électrique aux bornes du deuxième bolomètre au sein du circuit de lecture et de compensation peut également permettre de calculer, à partir de la mesure de cette tension, la résistance électrique du ou des deuxièmes bolomètres de compensation. Moyennant la connaissance de la valeur de la résistance électrique du ou des bolomètres de compensation, le dispositif de détection infrarouge selon l'invention permet également dans ce cas de connaître le courant circulant dans le bolomètre de compensation ou chacun des bolomètres de compensation du dispositif de détection indépendamment les uns des autres.

Le dispositif de détection infrarouge selon l'invention permet donc de régler au mieux la polarisation du premier et du deuxième bolomètres pour obtenir la performance nominale du dispositif et d'élaborer avec une meilleure précision les modèles numériques simulant le fonctionnement et les performances des pixels du dispositif. Par rapport aux dispositifs de détection de l'art antérieur, le dispositif selon l'invention permet notamment de s'affranchir des problèmes de rendement des pixels sur la matrice, par exemple dans le cas de pixels défectueux, qui sont susceptibles de fausser la valeur de la consommation de l'alimentation électrique des pixels.

Le dispositif de détection infrarouge selon l'invention permet également de mesurer les résistances électriques du ou des bolomètres sensibles et/ou du ou des bolomètres de compensation, et de calculer les courants traversant le ou les bolomètres sensibles et/ou le ou les bolomètres de compensation sans faire varier un potentiel électrique d'alimentation appliqué sur le ou les bolomètres sensibles et/ou sur le ou les bolomètres de compensation, et donc de s'affranchir des problèmes de mesure lorsque ce potentiel électrique n'est pas modifiable (reliée à la masse du circuit par exemple ou aux caissons des transistors MOS). De plus, pour cette mesure, lorsque le premier bolomètre et le deuxième bolomètre sont couplés électriquement à des transistors MOS permettant de polariser ces bolomètres, le dispositif de détection selon l'invention permet de s'affranchir des dispersions technologiques des résistances séries de ces transistors MOS d'injection et de polarisation du pont bolométrique. Par rapport aux dispositifs de détection de l'art antérieur, le dispositif de détection selon l'invention permet donc de gagner en précision sur la mesure de la résistance électrique du ou des bolomètres sensibles et/ou du ou des bolomètres de compensation, et ce d'autant plus que cette valeur est faible.

Le dispositif de détection infrarouge selon l'invention permet d'améliorer et de faciliter la mesure des résistances électriques du ou des bolomètres sensibles et/ou du ou des bolomètres de compensation, quelques soient les contraintes de fonctionnement du circuit de lecture et de compensation en termes d'alimentation électrique.

Le dispositif de détection infrarouge peut comporter en outre des moyens de polarisation du premier bolomètre et du deuxième bolomètre. Ces moyens de polarisation peuvent comporter au moins un premier transistor MOS couplé électriquement à une borne du premier bolomètre et au moins un deuxième transistor MOS couplé électriquement à une borne du deuxième bolomètre.

Selon l'invention, les premiers moyens de lecture comportent au moins un premier amplificateur opérationnel apte à réaliser une intégration d'un premier courant destiné à traverser le premier bolomètre, correspondant au premier signal électrique, et auquel est soustrait un deuxième courant, correspondant au deuxième signal électrique, destiné à traverser le deuxième bolomètre.

Les deuxièmes moyens de lecture peuvent comporter au moins un deuxième amplificateur opérationnel monté en suiveur de tension et comportant une entrée reliée électriquement à l'une des bornes du premier bolomètre via un interrupteur situé dans un pixel du dispositif de détection infrarouge, le pixel comportant le premier bolomètre, et/ou reliée électriquement à l'une des bornes du deuxième bolomètre. Lorsque le premier bolomètre fait partie d'un pixel d'une matrice de pixels dont les lignes sont lues séquentiellement, l'interrupteur permettant de lire la tension aux bornes du premier bolomètre peut être activé de manière synchrone avec un signal d'adressage de la ligne comportant le premier bolomètre.

Dans ce cas, les deuxièmes moyens de lecture peuvent comporter en outre des moyens aptes à relier électriquement une sortie du dispositif de détection infrarouge avec une sortie des premiers moyens de lecture ou avec une sortie du deuxième amplificateur opérationnel.

Selon l'invention, les deuxièmes moyens de lecture comportent une pluralité d'interrupteurs aptes à relier électriquement, dans une première configuration, une première entrée du premier amplificateur opérationnel à une liaison électrique reliant le premier bolomètre au deuxième bolomètre, et à relier électriquement, dans une deuxième configuration, une deuxième entrée du premier amplificateur opérationnel à l'une des bornes du premier bolomètre via l'un des interrupteurs situé dans un pixel du dispositif de détection infrarouge, le pixel comportant le premier bolomètre, et/ou à l'une des bornes du deuxième bolomètre, et tel que le premier amplificateur opérationnel soit monté en intégrateur dans la première configuration ou en suiveur de tension dans la deuxième configuration. Par rapport à des deuxièmes moyens de lecture comportant un amplificateur opérationnel supplémentaire, cette variante comportant des deuxièmes moyens de lecture formés d'interrupteurs simplifie l'intégration d'au moins une partie de ces deuxièmes moyens de lecture dans un pied de colonne de la matrice et/ou directement dans les pixels de la matrice grâce notamment à un gain de place de ces interrupteurs par rapport à un amplificateur opérationnel supplémentaire. Les interrupteurs peuvent être réalisés par des transistors MOS, l'état fermé ou ouvert d'un interrupteur correspondant dans ce cas à l'état bloqué ou passant du transistor MOS.

Dans cette variante, les interrupteurs peuvent être aptes à relier électriquement, dans la première configuration, la deuxième entrée du premier amplificateur opérationnel à un potentiel électrique de polarisation, et aptes à relier électriquement, dans la deuxième configuration, ladite liaison électrique au potentiel électrique de polarisation.

Le dispositif de détection infrarouge peut comporter une matrice de pixels telle que chaque pixel comporte au moins un premier bolomètre apte à détecter une partie du rayonnement infrarouge destiné à être reçu par le dispositif de détection infrarouge, et dans lequel chaque ligne ou chaque colonne de pixels de la matrice est couplée électriquement à un circuit de lecture et de compensation comprenant au moins :

- un deuxième bolomètre couplé électriquement aux premiers bolomètres de ladite ligne ou colonne de pixels et insensible au rayonnement infrarouge destiné à être reçu par le dispositif de détection infrarouge ;
- des premiers moyens de lecture de premiers signaux électriques destinés à être délivrés par les premiers bolomètres de ladite ligne ou colonne de pixels auxquels est soustrait un deuxième signal électrique destiné à être délivré par le deuxième bolomètre ;
- des deuxièmes moyens de lecture d'une tension électrique aux bornes du premier bolomètre via un interrupteur situé dans le pixel et/ou d'une tension électrique aux bornes du deuxième bolomètre.

Les deuxièmes moyens peuvent être aptes à lire la tension électrique aux bornes du premier bolomètre via l'interrupteur situé dans le pixel et aptes à lire la tension électrique aux bornes du deuxième bolomètre via un deuxième interrupteur situé dans le circuit de lecture et de compensation.

Le dispositif de détection infrarouge peut être tel que :

- le premier bolomètre peut comporter une première borne reliée électriquement à un premier potentiel électrique d'alimentation, et une deuxième borne reliée électriquement à la source d'un premier transistor MOS ;
- le deuxième bolomètre peut comporter une première borne reliée électriquement à une première électrode d'un deuxième transistor MOS correspondant à la source du deuxième transistor MOS, et une deuxième borne reliée électriquement à un deuxième potentiel électrique d'alimentation ;
- une entrée des premiers moyens de lecture peut être reliée électriquement à une deuxième électrode du deuxième transistor MOS correspondant au drain du deuxième transistor MOS ;

- une entrée des deuxièmes moyens de lecture peut être reliée électriquement à la deuxième borne du premier bolomètre via un interrupteur situé dans le pixel et/ou à la première borne du deuxième bolomètre.

L'invention concerne également un procédé de détection infrarouge mis en oeuvre à partir d'un dispositif de détection infrarouge tel que décrit ci-dessus, pouvant comporter au moins les étapes de :

- polarisation du premier transistor MOS et du deuxième transistor MOS tels que le premier transistor MOS soit en régime ohmique et que le deuxième transistor MOS soit à l'état bloqué, puis
- intégration, pendant une durée T, du courant traversant le premier bolomètre dans une capacité de valeur C couplée au premier amplificateur opérationnel, puis
- mesure d'une tension de sortie $V_{out}$ du premier amplificateur opérationnel, puis
- mesure, par les deuxièmes moyens de lecture, d'un premier potentiel électrique $V_{S1}$ à la deuxième borne du premier bolomètre, puis
- calcul d'une résistance électrique $R_{sens}$ du premier bolomètre tel que :

$$R_{sens} = \left| \frac{VDET - V_{S1}}{\left(V_{out} - V_{bus}\right) \times \frac{C}{T}} \right| ,$$

avec VDET : premier potentiel électrique d'alimentation appliqué sur la première borne du premier bolomètre ;
$V_{bus}$ : potentiel électrique de polarisation appliqué sur une entrée du premier amplificateur opérationnel ;
et/ou comportant au moins les étapes de :

- polarisation du premier transistor MOS et du deuxième transistor MOS tels que le premier transistor MOS soit à l'état bloqué et que le deuxième transistor MOS soit en régime ohmique, puis
- intégration, pendant une durée T, du courant traversant le deuxième bolomètre dans la capacité de valeur C couplée au premier amplificateur opérationnel, puis
- mesure d'une tension de sortie $V_{out}$ du premier amplificateur opérationnel, puis
- mesure, par les deuxièmes moyens de lecture, d'un premier potentiel électrique $V_{S1'}$ à la première borne du deuxième bolomètre, puis
- calcul d'une résistance électrique $R_{comp}$ du deuxième bolomètre tel que :

$$R_{comp} = \left| \frac{V_{S1'} - VSK}{\left(V_{out} - V_{bus}\right) \times \frac{C}{T}} \right| ,$$

avec VSK : deuxième potentiel électrique d'alimentation appliqué sur la deuxième borne du deuxième bolomètre.

Le procédé de détection infrarouge peut comporter en outre, lorsque l'étape de calcul de la résistance électrique $R_{sens}$ est mise en oeuvre, les étapes de :

- polarisation du premier transistor MOS et du deuxième transistor MOS tels qu'un courant traversant le premier bolomètre soit sensiblement égal à un courant traversant le deuxième bolomètre, puis
- mesure, par les deuxièmes moyens de lecture, d'un deuxième potentiel électrique $V_{S2}$ à la deuxième borne du premier bolomètre, puis
- calcul d'un courant $I_{sens}$ traversant le premier bolomètre tel que :

$$I_{sens} = \frac{VDET - V_{S2}}{R_{sens}} ,$$

et/ou peut comporter en outre, lorsque l'étape de calcul de la résistance électrique $R_{comp}$ est mise en oeuvre, les étapes de :

- polarisation du premier transistor MOS et du deuxième transistor MOS tels qu'un courant traversant le premier bolomètre soit sensiblement égal à un courant traversant le deuxième bolomètre, puis
- mesure, par les deuxièmes moyens de lecture, d'un deuxième potentiel électrique $V_{S2'}$ à la première borne du deuxième bolomètre, puis
- calcul d'un courant $I_{comp}$ traversant le deuxième bolomètre tel que :

$$I_{comp} = \frac{V_{S2'} - VSK}{R_{comp}}.$$

BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :

- la figure 1 représente une partie d'un dispositif de détection infrarouge bolométrique selon l'art antérieur ;
- la figure 2 représente une partie d'un dispositif de détection infrarouge selon un exemple utile à la compréhension de l'invention ;
- les figures 3 et 4 représentent une partie de dispositifs de détection infrarouge, objets de la présente invention, selon des premier et deuxième modes de réalisation.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

EXPOSÉ DÉTAILLÉ DE MODES DE RÉALISATION PARTICULIERS

On se réfère tout d'abord à la figure 2 qui représente un dispositif de détection infrarouge 100 selon un exemple utile à la compréhension de l'invention.

Le dispositif de détection infrarouge 100 comporte une matrice de pixels 102. Un seul pixel 104 de cette matrice 102 est représenté sur la figure 2 et est par exemple similaire au pixel 10 précédemment décrit en liaison avec la figure 1. Le pixel 104 comporte donc un premier bolomètre 106 apte à détecter une partie d'un rayonnement infrarouge destiné à être reçu par le dispositif de détection 100, et donc sensible thermiquement à ce rayonnement. Le premier bolomètre 106 comporte une première borne reliée électriquement à un premier potentiel électrique d'alimentation VDET et une deuxième borne reliée électriquement à la source d'un premier transistor MOS 108, ici de type PMOS, formant un transistor d'injection vis-à-vis du premier bolomètre 106.

Les pixels de la matrice 102 sont ici disposés en lignes et colonnes afin de former une matrice rectangulaire de pixels. Chaque colonne de pixels de la matrice 102 est reliée à un circuit de lecture et de compensation 110 qui permet de réaliser la lecture des signaux délivrés par les pixels de la colonne qui lui est associée et une compensation thermique de ces signaux via au moins un bolomètre de compensation intégré à ce circuit 110. Seule la partie du circuit 110 à laquelle est reliée la colonne de pixels à laquelle appartient le pixel 104 est représentée sur la figure 1 et décrite ci-dessous.

Dans le dispositif décrit ici, le circuit de lecture et de compensation 110 comporte tous les élément du circuit de lecture et de compensation précédemment décrit en liaison avec la figure 1, c'est-à-dire un deuxième bolomètre 112 formant un bolomètre de compensation, un deuxième transistor MOS 114 d'injection, ici de type NMOS, dont la source est reliée à une première borne du deuxième bolomètre 112, un premier amplificateur opérationnel 116 monté en intégrateur et dont l'entrée non inverseuse est reliée au drain du deuxième transistor MOS 114 et dont la sortie est rebouclée sur son entrée non inverseuse via une capacité d'intégration 118 couplée en parallèle à un interrupteur 120. Un potentiel électrique de polarisation $V_{bus}$ est appliqué sur une entrée inverseuse du premier amplificateur 116, et un deuxième potentiel électrique d'alimentation VSK est appliqué sur une deuxième borne du deuxième bolomètre 112.

Les pixels de la colonne à laquelle appartient le pixel 104 sont reliés séquentiellement (ligne par ligne) au deuxième bolomètre 112 de compensation au fur et à mesure de la lecture séquentielle des lignes de pixels de la matrice 102, par exemple via des interrupteurs (non représentés sur la figure 2) commandés par des signaux d'adressage.

Le circuit de lecture et de compensation 110 comporte en outre un deuxième amplificateur opérationnel 122 monté en suiveur de tension (comportant sa sortie rebouclée directement sur son entrée inverseuse) et dont l'entrée non inverseuse est reliée à la source du premier transistor MOS 108 via un interrupteur 109, et donc également à la deuxième borne du premier bolomètre sensible 106. L'interrupteur 109 est commandé de manière synchrone avec la commande d'adressage permettant de relier le pixel 104 au deuxième bolomètre 112 de compensation. Un multiplexeur 124 permet de relier une sortie 126 du circuit de lecture 110, sur laquelle un amplificateur vidéo est par exemple destiné à être relié, soit à la sortie du premier amplificateur opérationnel 116 soit à la sortie du deuxième amplificateur opérationnel 122.

Le deuxième amplificateur opérationnel 122 permet de lire directement un potentiel électrique Vs à la deuxième borne du premier bolomètre 106, et donc de lire une tension aux bornes du premier bolomètre 106. Le multiplexeur 124 permet de sélectionner l'information destinée à être lue sur la sortie 126: soit une tension $V_{out}$ de sortie du premier amplificateur opérationnel 116, correspondant à l'information délivrée par le pixel de la colonne qui est lu, soit le potentiel électrique Vs.

La source du premier transistor MOS 108 n'est pas perturbé lors du changement de position du multiplexeur 124 car quelque soit cette position, la source du premier transistor MOS 108 voit physiquement une impédance élevée grâce à la présence du deuxième amplificateur opérationnel 122 ou à l'ouverture de l'interrupteur 109.

Pour mesurer la résistance électrique $R_{sens}$ du premier bolomètre sensible 106 et/ou le courant $I_{sens}$ traversant le premier bolomètre sensible 106, le protocole suivant est appliqué :

Le premier transistor MOS 108 et le deuxième transistor MOS 114 sont tout d'abord polarisés tels que le premier transistor MOS 108 soit en régime ohmique et que le deuxième transistor MOS 114 soit à l'état bloqué. Le pont bolométrique est ainsi bloqué d'un côté. Le multiplexeur 124 est configuré tel que la sortie 126 soit reliée électriquement à la sortie du premier amplificateur 116. Une intégration, pendant une durée T, du courant $I_{sens}$ traversant le premier bolomètre 106 (ainsi que le premier transistor MOS 108 en régime ohmique), par le premier amplificateur 116 et la capacité 118 (capacité de valeur C), est ensuite réalisée. Lors de cette intégration, l'interrupteur 120 est ouvert pendant cette durée T. La tension $V_{out}$ sur la sortie 126 est alors mesurée à la fin de la durée T. Le multiplexeur 124 est ensuite configuré tel que la sortie 126 du circuit 110 soit reliée électriquement à la sortie du deuxième amplificateur opérationnel 122. L'interrupteur 109 étant alors en position fermée, un premier potentiel électrique $V_{S1}$ à la deuxième borne du premier bolomètre 106 est mesuré.

Connaissant la tension aux bornes du premier bolomètre sensible 106 (via la mesure de $V_{S1}$ et de la connaissance du potentiel électrique VDET) et le courant circulant dans la branche sensible (via la tension $V_{out}$ mesurée), on en déduit la résistance électrique $R_{sens}$ du premier bolomètre sensible 106 :

$$R_{sens} = \frac{VDET - V_{S1}}{I_{sens}} = \left| \frac{VDET - V_{S1}}{(V_{out} - V_{bus}) \times \dfrac{C}{T}} \right| \qquad (3)$$

La valeur de la résistance électrique $R_{sens}$ est ici déterminée sans approximation du fait notamment que l'on s'affranchit de la résistance parasite du transistor MOS d'injection.

Le fonctionnement du dispositif 100 est ensuite basculé en mode imagerie. Le pont bolométrique va alors être équilibré. Dans ce mode, la connaissance précise du courant circulant dans les bolomètres actifs est un avantage à la fois pour régler le détecteur dans sa configuration la plus performante, et pour alimenter les modèles de simulation numérique avec des données expérimentales fiables.

Pour obtenir la valeur du courant $I_{sens}$ qui est caractéristique de la performance globale du dispositif 100, on polarise le premier transistor MOS 108 et le deuxième transistor MOS 114 (via l'application de tensions de polarisation sur les grilles de ces deux transistors) tel qu'un courant $I_{sens}$ traversant le premier bolomètre 106 soit égal au courant $I_{comp}$ traversant le deuxième bolomètre 112, équilibrant ainsi le pont bolométrique. Le multiplexeur 124 est configuré tel que la sortie 126 du circuit 110 soit reliée électriquement à la sortie du deuxième amplificateur opérationnel 122. On mesure ensuite de nouveau le potentiel électrique Vs dans ces nouvelles conditions de polarisation à la deuxième borne du premier bolomètre 106, ce potentiel étant appelé deuxième potentiel électrique $V_{S2}$ et correspondant à celui obtenu sur la sortie 126.

Pour connaître le courant $I_{sens}$ traversant le premier bolomètre sensible 106, la nouvelle mesure de Vs précédemment réalisée et le précédent calcul de la résistance électrique $R_{sens}$ du premier bolomètre sensible 106, permettent de remonter à la valeur de ce courant :

$$I_{sens} = \frac{VDET - V_{S2}}{R_{sens}} \qquad (4)$$

Le circuit de lecture et de compensation 110 comporte des moyens analogues pour chaque colonne de pixels de la matrice 104, et comporte donc des moyens pour lire une tension aux bornes de chacun des bolomètres sensibles du circuit 110, ce qui permet de calculer la résistance électrique de chaque bolomètre sensible du circuit 110 ainsi que le courant circulant dans chaque bolomètre sensible du dispositif 100.

Une lecture classique du rayonnement infrarouge détecté par le pixel 104 est réalisée est configurant le multiplexeur 124 tel que la sortie 126 soit reliée électriquement à la sortie du premier amplificateur 116, et en laissant l'interrupteur 120 ouvert tel que le courant di soit intégré dans la capacité 118 et que la tension $V_{out}$ lue sur la sortie 126 corresponde à l'information capturée par le pixel 104. L'interrupteur 120 est ensuite fermé afin de réinitialiser la capacité 118, vidant les charges électriques stockées dans la capacité 118, puis remis en position ouverte lors de la lecture d'un autre pixel de la colonne à laquelle appartient le pixel 104.

Selon une variante, le dispositif de détection infrarouge 100 peut également être réalisé tel qu'il permette de mesurer la résistance électrique $R_{comp}$ du deuxième bolomètre 112 de compensation et éventuellement du courant $I_{comp}$ traversant le deuxième bolomètre 112 de compensation. Selon cette variante, lors de la mesure de la résistance électrique $R_{comp}$ ou du courant $I_{comp}$, l'entrée non inverseuse du deuxième amplificateur opérationnel 122 n'est pas reliée électriquement à la deuxième borne du premier bolomètre 106 via l'interrupteur 109, mais est reliée à la première borne du deuxième bolomètre 112 de compensation.

Pour mesurer la résistance électrique $R_{comp}$ du deuxième bolomètre de compensation 112 et/ou le courant $I_{comp}$ traversant le deuxième bolomètre de compensation 112, le protocole suivant est appliqué :

Le premier transistor MOS 108 et le deuxième transistor MOS 114 sont tout d'abord polarisés tels que le deuxième transistor MOS 114 soit en régime ohmique et que le premier transistor MOS 108 soit à l'état bloqué. Le pont bolométrique est ainsi bloqué d'un côté. Le multiplexeur 124 est configuré tel que la sortie 126 soit reliée électriquement à la sortie du premier amplificateur 116. Une intégration, pendant une durée T, du courant $I_{comp}$ traversant le deuxième bolomètre 112 (ainsi que le deuxième transistor MOS 114 en régime ohmique), par le premier amplificateur 116 et la capacité 118 (capacité de valeur C), est ensuite réalisée. Lors de cette intégration, l'interrupteur 120 est ouvert. La tension $V_{out}$ sur la sortie 126 est alors mesurée à la fin de la durée T. Le multiplexeur 124 est ensuite configuré tel que la sortie 126 du circuit 110 soit reliée électriquement à la sortie du deuxième amplificateur opérationnel 122. Un premier potentiel électrique $V_{S1'}$ à la première borne du deuxième bolomètre 112 est alors mesuré.

Connaissant la tension aux bornes du deuxième bolomètre 112 (via la mesure de $V_{S1'}$ et de la connaissance du potentiel électrique VSK) et le courant circulant dans la branche de compensation (via la tension $V_{out}$ mesurée), on en déduit la résistance électrique $R_{comp}$ du deuxième bolomètre de compensation 112:

$$R_{comp} = \left| \frac{V_{S1'} - VSK}{(V_{out} - V_{bus}) \times \dfrac{C}{T}} \right| \qquad (5)$$

Comme précédemment décrit, le fonctionnement du dispositif 100 est ensuite basculé en mode imagerie. Le pont bolométrique va alors être équilibré. Pour obtenir la valeur du courant $I_{comp}$ qui est également caractéristique de la performance globale du détecteur, on polarise le premier transistor MOS 108 et le deuxième transistor MOS 114 (via l'application de tensions de polarisation sur les grilles de ces deux transistors) tel qu'un courant $I_{sens}$ traversant le premier bolomètre 106 soit égal au courant $I_{comp}$ traversant le deuxième bolomètre 112, équilibrant ainsi le pont bolométrique. Le multiplexeur 124 est configuré tel que la sortie 126 du circuit 110 soit reliée électriquement à la sortie du deuxième amplificateur opérationnel 122. On mesure ensuite de nouveau le potentiel électrique Vs dans ces nouvelles conditions de polarisation à la première borne du deuxième bolomètre 112, ce potentiel étant appelé deuxième potentiel électrique $V_{S2'}$ et correspondant à celui obtenu sur la sortie 126.

Pour connaître le courant $I_{comp}$ traversant le deuxième bolomètre 112, la nouvelle mesure de Vs précédemment réalisée et le précédent calcul de la résistance électrique $R_{comp}$ du deuxième bolomètre 112, permettent de remonter à la valeur de ce courant :

$$I_{comp} = \frac{V_{S2'} - VSK}{R_{comp}} \qquad (6)$$

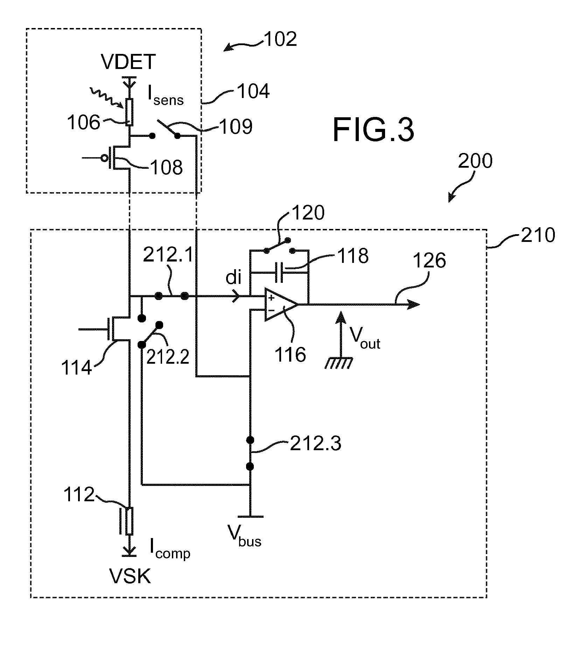

On décrit maintenant en liaison avec la figure 3 un dispositif de détection infrarouge 200 selon un premier mode de réalisation.

Le dispositif de détection 200 comporte une matrice de pixels 102 similaire à celle du dispositif de détection 100. Le dispositif 200 comporte en outre un circuit de lecture et de compensation 210 comportant, comme le circuit de lecture 110 précédemment décrit, pour chaque pixel, le premier bolomètre sensible 106, le premier transistor MOS 108, le premier amplificateur 116 couplé à la capacité 118 et à l'interrupteur 120.

Contrairement au circuit 110 dont les moyens de lecture de la tension aux bornes du premier bolomètre sensible 106 et/ou de la tension aux bornes du deuxième bolomètre de compensation 112 (ce qui implique dans ce cas, à la place de la liaison électrique entre l'entrée non inverseuse du premier amplificateur 116 et la deuxième borne du premier bolomètre 106, une liaison électrique entre l'entrée non inverseuse du premier amplificateur 116 et la première borne du deuxième bolomètre 112) comportent le deuxième amplificateur opérationnel 122 monté en suiveur de tension, la lecture de cette tension (du potentiel Vs) est réalisée par le premier amplificateur 116. Pour cela, le circuit de lecture et de compensation 210 comporte plusieurs interrupteurs, référencés 212.1 à 212.3, qui, dans une première configuration, relient électriquement l'entrée non inverseuse du premier amplificateur 116 au drain du premier transistor MOS 108 et relient électriquement l'entrée inverseuse du premier l'amplificateur 116 au potentiel électrique de polarisation $V_{bus}$. Dans cette première configuration, le premier amplificateur 116 est monté en intégrateur et permet de réaliser l'intégration du courant di, comme précédemment décrit pour le dispositif de détection 100. Dans cette première configuration, qui est visible sur la figure 3, le premier interrupteur 212.1 et le troisième interrupteur 212.3 sont fermés, tandis que le deuxième interrupteur 212.2 et l'interrupteur 109 dans le pixel 104 sont ouverts.

Dans une deuxième configuration, les états ouverts ou fermés des interrupteurs 212.1 à 212.3 et 109 sont inversés par rapport à ceux de la première configuration. Dans l'exemple décrit ici, le premier interrupteur 212.1 et le troisième interrupteur 212.3 sont alors ouverts, tandis que le deuxième interrupteur 212.2 et l'interrupteur 109 sont fermés. De plus, dans cette deuxième configuration, l'interrupteur 120 qui sert, lors de la lecture de pixels, à réinitialiser la capacité 118, est ici fermé. Ainsi, dans cette deuxième configuration, la sortie du premier amplificateur 116 est rebouclée directement sur l'entrée non inverseuse du premier amplificateur 116 et aucun signal autre que le signal de sortie n'est appliqué sur cette entrée non inverseuse. Le premier amplificateur 116 se retrouve donc monté en suiveur de tension, et permet de retranscrire sur sa sortie le potentiel électrique appliqué sur son entrée inverseuse. Du fait que le quatrième interrupteur 109 est fermé et que le troisième interrupteur 212.3 est ouvert, le potentiel électrique Vs est donc appliqué sur l'entrée inverseuse du premier amplificateur 116. Dans cette deuxième configuration, c'est donc le premier amplificateur 116 qui permet de lire la tension aux bornes du premier bolomètre sensible 106 et/ou aux bornes du deuxième bolomètre de compensation 112. De plus, du fait que dans cette deuxième configuration le deuxième interrupteur 212.2 soit fermé, le potentiel électrique de polarisation $V_{bus}$ se retrouve appliqué sur le drain du premier transistor MOS 108 et sur le drain du deuxième transistor MOS 114, ce qui permet d'éviter que ces électrodes des transistors MOS 108 et 114 soient en l'air et d'avoir les mêmes conditions de polarisation que dans la première configuration.

Dans ce circuit de lecture et de compensation 210, la sortie 126 est toujours reliée à la sortie du premier amplificateur 116 du fait que le premier amplificateur 116 sert à la fois à réaliser l'intégration du courant délivré par les bolomètres (l'amplificateur 116 est alors monté en intégrateur) et à la lecture de la tension aux bornes du premier bolomètre sensible 106 et/ou aux bornes du deuxième bolomètre de compensation 112 (l'amplificateur 116 est alors monté en suiveur de tension) selon la configuration dans laquelle se trouvent les interrupteurs 212.1 à 212.3 et 109. Ces interrupteurs 212.1 à 212.3 et 109 sont par exemple réalisés par 4 transistors MOS mis à l'état passant ou à l'état bloqué suivant la configuration envisagée.

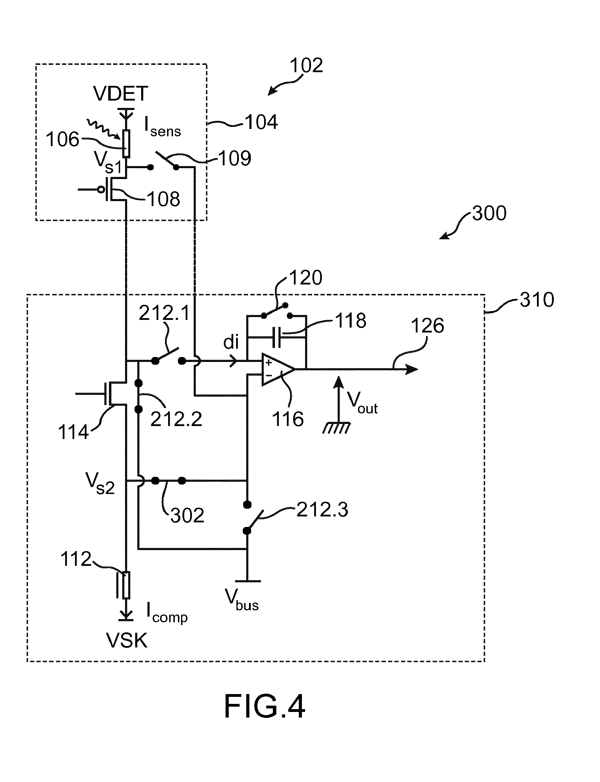

On décrit maintenant en liaison avec la figure 4 un dispositif de détection infrarouge 300 selon un deuxième mode de réalisation.

Le fonctionnement du dispositif de détection 300 est ici analogue à celui du dispositif de détection 200 précédemment décrit. Ainsi, dans le dispositif de détection 300 décrit ici, la lecture de la tension aux bornes du premier bolomètre sensible 106 est réalisée par le premier amplificateur 116 et les quatre interrupteurs 212.1 à 212.3 et 109 lorsque ceux-ci sont dans leur deuxième configuration comme précédemment décrit pour le dispositif de détection 200, le premier amplificateur 116 étant dans ce cas monté en suiveur de la tension $V_{S1}$ au niveau de la deuxième borne du premier bolomètre 106 (avec l'interrupteur 120 en position fermée). Lorsque les quatre interrupteurs 212.1 à 212.3 et 109 sont dans leur première configuration, le premier amplificateur 116 est alors monté en intégrateur et permet d'intégrer le courant arrivant sur son entrée non inverseuse. Dans cette première configuration, l'interrupteur 120 est ouvert.

Le dispositif de détection 300 comporte en outre un autre interrupteur 302 permettant de relier ou non la première borne du deuxième bolomètre 112 de compensation à l'entrée non inverseuse du premier amplicateur 116. Dans la première et la deuxième configuration des interrupteurs 212.1 à 212.3 et 109, l'interrupteur 302 est en position ouverte. Dans une troisième configuration distincte des deux autres configurations, les interrupteurs 212.1, 109 et 212.3 sont en position ouverte et les interrupteurs 212.2, 120 et 302 sont en position fermée (cas représenté sur la figure 4). Ainsi, dans cette troisième configuration, le premier amplificateur 116 est alors monté en suiveur de tension et permet de lire la tension aux bornes du deuxième bolomètre 112 de compensation, le potentiel électrique $V_{S2}$ à la première borne du deuxième bolomètre 112 de compensation se retrouvant sur la sortie 126. Ainsi, il est possible de mesurer la résistance électrique du deuxième bolomètre 112 de compensation et estimer également le courant circulant dans le deuxième bolomètre 112 de compensation, en mettant en oeuvre des étapes analogues à celles précédemment décrites en liaison avec les variantes des précédents modes de réalisation du dispositif de détection 100 et 200, mais avec les interrupteurs 212.1 à 212.3, 109 et 302 dans leur troisième configuration.

Pour cela, on polarise le premier transistor MOS 108 et le deuxième transistor MOS 114 tels que le premier transistor MOS 108 soit à l'état bloqué et que le deuxième transistor MOS 114 soit en régime ohmique, puis on réalise une intégration, pendant une durée T, du courant traversant le deuxième bolomètre 112 de compensation dans la capacité 118. La tension de sortie $V_{out}$ du premier amplificateur opérationnel 116 est alors mesurée.

On réalise ensuite une mesure du potentiel électrique $V_{S2}$ au niveau de la première borne du deuxième bolomètre 112 en commutant les interrupteurs 212.1 - 212.3, 109 et 302 dans la troisième configuration. On calcule alors la résistance électrique $R_{comp}$ du deuxième bolomètre 112 tel que :

$$R_{comp} = \left| \frac{VSK - V_{S2}}{\left(V_{out} - V_{bus}\right) \times \dfrac{C}{T}} \right| \qquad (7)$$

Ensuite, on polarise le premier transistor MOS 108 et le deuxième transistor MOS 114 tels qu'un courant traversant le premier bolomètre 106 soit sensiblement égal au courant traversant le deuxième bolomètre 112.

Dans ces conditions de polarisation (pont bolométrique équilibré), on réalise ensuite une mesure du potentiel électrique $V_{S2'}$ en commutant les interrupteurs 212.1 - 212.3, 109 et 302 dans la troisième configuration. Il est ensuite possible de calculer le courant $I_{comp}$ traversant le deuxième bolomètre 112 tel que :

$$I_{comp} = \frac{V_{S2'} - VSK}{R_{comp}} \qquad (8)$$

En variante du dispositif de détection 300, il est possible que les moyens de lecture de la tension aux bornes du deuxième bolomètre 112 comportent le deuxième amplificateur opérationnel 122 et le multiplexeur 124 en remplacement des interrupteurs 212.1 à 212.3 et 109.

De plus, lorsque le dispositif de détection comporte le deuxième amplificateur opérationnel 122 monté en suiveur, il est également possible d'ajouter l'interrupteur 302 ainsi qu'un autre interrupteur entre l'entrée non inverseuse du deuxième amplificateur opérationnel 122 et la première borne du deuxième bolomètre 112. Ainsi, selon la configuration de ces deux interrupteurs, le deuxième amplificateur opérationnel peut être utilisé pour lire la tension aux bornes du premier bolomètre 106 ou du deuxième bolomètre 112.

Les premier et deuxième modes de réalisation précédemment décrits peuvent en variante être réalisés tels que les circuits de lecture et de compensation 210 et 310 soient directement intégrés dans les pixels.

Dans tous les modes de réalisations et variantes envisagés, il est possible de réaliser un asservissement des tensions de polarisation appliquées sur les grilles des transistors MOS 108 et 114 en fonction du courant circulant dans les bolomètres. Un tel asservissement permet alors de trouver le point de polarisation optimum du dispositif de détection et donc d'optimiser formellement le couple performance / consommation pour chaque détecteur, ce qui est avantageux notamment lors d'un changement dans la technologie de réalisation du dispositif de détection (nouveau fondeur CMOS ou nouveau design de pixel par exemple).

Dans tous les modes de réalisation et variantes précédemment décrits, il est possible que le substrat sur lequel est réalisé le dispositif de détection soit régulé thermiquement.

Selon une variante des différents exemples et modes de réalisation précédemment décrit, il est possible d'avoir un bolomètre de référence disposé en tête de chaque ligne de la matrice de pixels à la place du bolomètre de compensation disposé en pied de colonne. Dans ce cas, par un jeu de miroirs de courant, le courant circulant dans le bolomètre de référence est recopié et soustrait des courants issus des bolomètres sensibles. Les différents moyens précédemment décrits peuvent dans ce cas être utilisés pour mesurer la résistance électrique des bolomètres sensibles et le courant traversant les bolomètres sensibles.

**Revendications**

1. Dispositif de détection infrarouge (100, 200, 300) comportant au moins un premier bolomètre (106) apte à détecter au moins une partie d'un rayonnement infrarouge destiné à être reçu par le dispositif de détection infrarouge (100, 200, 300), et un circuit de lecture et de compensation (110, 210, 310) d'un premier signal électrique destiné à être délivré par le premier bolomètre (106), le circuit de lecture et de compensation (110, 210, 310) comprenant au moins :

   - un deuxième bolomètre (112) couplé électriquement au premier bolomètre (106) et insensible au rayonnement infrarouge destiné à être reçu par le dispositif de détection infrarouge (100, 200, 300) ;
   - des premiers moyens (116, 118, 120) de lecture dudit premier signal électrique auquel est soustrait un deuxième signal électrique destiné à être délivré par le deuxième bolomètre (112) ;
   - des deuxièmes moyens (109, 116, 118, 120, 212.1 - 212.3, 302) de lecture d'une tension électrique aux bornes du premier bolomètre (106) et/ou d'une tension électrique aux bornes du deuxième bolomètre (112) ;

   dans lequel les premiers moyens (116, 118, 120) de lecture comportent au moins un premier amplificateur opérationnel (116) apte à réaliser une intégration d'un premier courant destiné à traverser le premier bolomètre (106), correspondant au premier signal électrique, et auquel est soustrait un deuxième courant, correspondant au deuxième signal électrique, destiné à traverser le deuxième bolomètre (112),
   et dans lequel les deuxièmes moyens (109, 116, 118, 120, 212.1- 212.3, 302) de lecture comportent une pluralité d'interrupteurs (109, 120, 212.1- 212.3) aptes à relier électriquement, dans une première configuration, une première entrée du premier amplificateur opérationnel (116) à une liaison électrique reliant le premier bolomètre (106) au deuxième bolomètre (112), et à relier électriquement, dans une deuxième configuration, une deuxième entrée du premier amplificateur opérationnel (116) à l'une des bornes du premier bolomètre (106) via l'un des interrupteurs (109) situé dans un pixel (104) du dispositif de détection infrarouge (100), le pixel (104) comportant le premier bolomètre (106), et/ou à l'une des bornes du deuxième bolomètre (112), et tel que le premier amplificateur opérationnel (116) soit monté en intégrateur dans la première configuration ou en suiveur de tension dans la deuxième configuration.

2. Dispositif de détection infrarouge (200, 300) selon la revendication 1, dans lequel les interrupteurs (212.2, 212.3) sont aptes à relier électriquement, dans la première configuration, la deuxième entrée du premier amplificateur opérationnel (116) à un potentiel électrique de polarisation ($V_{bus}$), et aptes à relier électriquement, dans la deuxième configuration, ladite liaison électrique au potentiel électrique de polarisation ($V_{bus}$).

3. Dispositif de détection infrarouge (100, 200, 300) selon l'une des revendications précédentes, comportant une matrice de pixels (102) telle que chaque pixel (104) comporte au moins un premier bolomètre (106) apte à détecter une partie du rayonnement infrarouge destiné à être reçu par le dispositif de détection infrarouge (100, 200, 300), et dans lequel chaque ligne ou chaque colonne de pixels de la matrice (102) est couplée électriquement à un circuit de lecture et de compensation (110, 210, 310) comprenant au moins :

   - un deuxième bolomètre (112) couplé électriquement aux premiers bolomètres (106) de ladite ligne ou colonne de pixels et insensible au rayonnement infrarouge destiné à être reçu par le dispositif de détection infrarouge (100, 200, 300) ;
   - des premiers moyens (116, 118, 120) de lecture de premiers signaux électriques destinés à être délivrés par les premiers bolomètres (106) de ladite ligne ou colonne de pixels auxquels est soustrait un deuxième signal électrique destiné à être délivré par le deuxième bolomètre (112) ;
   - des deuxièmes moyens (109, 116, 118, 120, 122, 124, 212.1 - 212.3, 302) de lecture d'une tension électrique aux bornes du premier bolomètre (106) via un interrupteur (109) situé dans le pixel (104) et/ou d'une tension électrique aux bornes du deuxième bolomètre (112).

4. Dispositif de détection infrarouge (300) selon la revendication 3, dans lequel les deuxièmes moyens (109, 116, 118, 120, 212.1 - 212.3, 302) sont aptes à lire la tension électrique aux bornes du premier bolomètre (106) via l'interrupteur (109) situé dans le pixel (104) et aptes à lire la tension électrique aux bornes du deuxième bolomètre (112) via un deuxième interrupteur (302) situé dans le circuit de lecture et de compensation (310).

**5.** Dispositif de détection infrarouge (100, 200, 300) selon l'une des revendications précédentes, dans lequel :

- le premier bolomètre (106) comporte une première borne reliée électriquement à un premier potentiel électrique d'alimentation (VDET), et une deuxième borne reliée électriquement à la source d'un premier transistor MOS (108) ;
- le deuxième bolomètre (112) comporte une première borne reliée électriquement à une première électrode d'un deuxième transistor MOS (114) correspondant à la source du deuxième transistor MOS (114), et une deuxième borne reliée électriquement à un deuxième potentiel électrique d'alimentation (VSK) ;
- une entrée des premiers moyens (116, 118, 120) de lecture est reliée électriquement à une deuxième électrode du deuxième transistor MOS (114) correspondant au drain du deuxième transistor MOS (114) ;
- une entrée des deuxièmes moyens (116, 118, 120, 122, 124, 212.1 - 212.3, 109, 302) de lecture est reliée électriquement à la deuxième borne du premier bolomètre (106) via un interrupteur (109) situé dans le pixel (104) et/ou à la première borne du deuxième bolomètre (112).

**6.** Procédé de détection infrarouge mis en oeuvre à partir d'un dispositif de détection infrarouge (100, 200, 300) selon la revendication 5, comportant au moins les étapes de :

- polarisation du premier transistor MOS (108) et du deuxième transistor MOS (114) tels que le premier transistor MOS (108) soit en régime ohmique et que le deuxième transistor MOS (114) soit à l'état bloqué, puis
- intégration, pendant une durée T, du courant traversant le premier bolomètre (106) dans une capacité (118) de valeur C couplée au premier amplificateur opérationnel (116), puis
- mesure d'une tension de sortie $V_{out}$ du premier amplificateur opérationnel, puis
- mesure, par les deuxièmes moyens (109, 116, 118, 120, 122, 124, 212.1- 212.3, 302) de lecture, d'un premier potentiel électrique $V_{S1}$ à la deuxième borne du premier bolomètre (106), puis
- calcul d'une résistance électrique $R_{sens}$ du premier bolomètre (106) tel que :

$$R_{sens} = \left| \frac{VDET - V_{S1}}{\left(V_{out} - V_{bus}\right) \times \dfrac{C}{T}} \right|,$$

avec VDET : premier potentiel électrique d'alimentation appliqué sur la première borne du premier bolomètre (106) ;

$V_{bus}$ : potentiel électrique de polarisation appliqué sur une entrée du premier amplificateur opérationnel (116) ; et/ou comportant au moins les étapes de :

- polarisation du premier transistor MOS (108) et du deuxième transistor MOS (114) tels que le premier transistor MOS (108) soit à l'état bloqué et que le deuxième transistor MOS (114) soit en régime ohmique, puis
- intégration, pendant une durée T, du courant traversant le deuxième bolomètre (106) dans la capacité (118) de valeur C couplée au premier amplificateur opérationnel (116), puis
- mesure d'une tension de sortie $V_{out}$ du premier amplificateur opérationnel (116), puis
- mesure, par les deuxièmes moyens (109, 116, 118, 120, 122, 124, 212.1- 212.3, 302) de lecture, d'un premier potentiel électrique $V_{S1'}$ à la première borne du deuxième bolomètre (112), puis
- calcul d'une résistance électrique $R_{comp}$ du deuxième bolomètre (112) tel que :

$$R_{comp} = \left| \frac{V_{S1'} - VSK}{\left(V_{out} - V_{bus}\right) \times \dfrac{C}{T}} \right|,$$

avec VSK : deuxième potentiel électrique d'alimentation appliqué sur la deuxième borne du deuxième bolomètre (112).

**7.** Procédé de détection infrarouge selon la revendication 6, comportant en outre, lorsque l'étape de calcul de la résistance électrique $R_{sens}$ est mise en oeuvre, les étapes de :

- polarisation du premier transistor MOS (108) et du deuxième transistor MOS (114) telle qu'un courant traversant le premier bolomètre (106) soit sensiblement égal à un courant traversant le deuxième bolomètre (112), puis
- mesure, par les deuxièmes moyens (116, 118, 120, 122, 124, 212.1 - 212.4, 302) de lecture, d'un deuxième potentiel électrique $V_{S2}$ à la deuxième borne du premier bolomètre (106), puis
- calcul d'un courant $I_{sens}$ traversant le premier bolomètre (106) tel que :

$$I_{sens} = \frac{VDET - V_{S2}}{R_{sens}},$$

et/ou comporte en outre, lorsque l'étape de calcul de la résistance électrique $R_{comp}$ est mise en oeuvre, les étapes de :
- polarisation du premier transistor MOS (108) et du deuxième transistor MOS (114) telle qu'un courant traversant le premier bolomètre (106) soit sensiblement égal à un courant traversant le deuxième bolomètre (112), puis
- mesure, par les deuxièmes moyens (116, 118, 120, 122, 124, 212.1 - 212.3, 109, 302) de lecture, d'un deuxième potentiel électrique $V_{S2'}$ à la première borne du deuxième bolomètre (112), puis
- calcul d'un courant $I_{comp}$ traversant le deuxième bolomètre (112) tel que :

$$I_{comp} = \frac{V_{S2'} - VSK}{R_{comp}}.$$

FIG.1

FIG.2

FIG.3

FIG.4

Europäisches
Patentamt

European
Patent Office

Office européen
des brevets

# RAPPORT DE RECHERCHE EUROPEENNE

Numéro de la demande

EP 14 20 0594

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| A | EP 2 163 871 A1 (ULIS [FR]) 17 mars 2010 (2010-03-17) * alinéas [0031] - [0033], [0035], [0036], [0038], [0039], [0042], [0050] - [0068], [0079] - [0086], [0089], [0097] - [0111] * * figures 2,5 * | 1-7 | INV. G01J5/22 |
| A | EP 2 071 309 A1 (ULIS [FR]) 17 juin 2009 (2009-06-17) * alinéas [0048], [0051], [0059], [0060], [0069], [0072] - [0083] * * figure 2 * | 1 | |
| A | EP 2 071 310 A1 (ULIS [FR]) 17 juin 2009 (2009-06-17) * alinéas [0060] - [0065] * * figure 3A * | 1 | |
| A | WO 2010/125281 A1 (ULIS [FR]; DUPONT BENOIT [BE]; VILAIN MICHEL [FR]) 4 novembre 2010 (2010-11-04) * page 11, ligne 3 - page 12, ligne 21 * * figure 2 * | 1 | DOMAINES TECHNIQUES RECHERCHES (IPC) G01J |

Le présent rapport a été établi pour toutes les revendications

| Lieu de la recherche | Date d'achèvement de la recherche | Examinateur |
|---|---|---|
| Munich | 30 avril 2015 | Jacquin, Jérôme |

CATEGORIE DES DOCUMENTS CITES

X : particulièrement pertinent à lui seul
Y : particulièrement pertinent en combinaison avec un
   autre document de la même catégorie
A : arrière-plan technologique
O : divulgation non-écrite
P : document intercalaire

T : théorie ou principe à la base de l'invention
E : document de brevet antérieur, mais publié à la
   date de dépôt ou après cette date
D : cité dans la demande
L : cité pour d'autres raisons
........................................................
& : membre de la même famille, document correspondant

EPO FORM 1503 03.82 (P04C02)

**ANNEXE AU RAPPORT DE RECHERCHE EUROPEENNE
RELATIF A LA DEMANDE DE BREVET EUROPEEN NO.**

EP 14 20 0594

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

30-04-2015

| Document brevet cité au rapport de recherche | | Date de publication | Membre(s) de la famille de brevet(s) | | Date de publication |
|---|---|---|---|---|---|
| EP 2163871 | A1 | 17-03-2010 | CN | 101676697 A | 24-03-2010 |
| | | | EP | 2163871 A1 | 17-03-2010 |
| | | | FR | 2936052 A1 | 19-03-2010 |
| | | | JP | 2010071987 A | 02-04-2010 |
| | | | JP | 2014157156 A | 28-08-2014 |
| | | | US | 2010065729 A1 | 18-03-2010 |
| EP 2071309 | A1 | 17-06-2009 | CA | 2647370 A1 | 12-06-2009 |
| | | | CN | 101458124 A | 17-06-2009 |
| | | | EP | 2071309 A1 | 17-06-2009 |
| | | | FR | 2925159 A1 | 19-06-2009 |
| | | | JP | 5548358 B2 | 16-07-2014 |
| | | | JP | 2009145330 A | 02-07-2009 |
| | | | RU | 2008147122 A | 10-06-2010 |
| | | | US | 2009152465 A1 | 18-06-2009 |
| EP 2071310 | A1 | 17-06-2009 | CA | 2647365 A1 | 12-06-2009 |
| | | | CN | 101458125 A | 17-06-2009 |
| | | | EP | 2071310 A1 | 17-06-2009 |
| | | | FR | 2925158 A1 | 19-06-2009 |
| | | | JP | 5548360 B2 | 16-07-2014 |
| | | | JP | 2009145336 A | 02-07-2009 |
| | | | RU | 2008148795 A | 20-06-2010 |
| | | | US | 2009152470 A1 | 18-06-2009 |
| WO 2010125281 | A1 | 04-11-2010 | CA | 2760468 A1 | 04-11-2010 |
| | | | CN | 102460096 A | 16-05-2012 |
| | | | EP | 2425220 A1 | 07-03-2012 |
| | | | FR | 2945120 A1 | 05-11-2010 |
| | | | JP | 2012525573 A | 22-10-2012 |
| | | | KR | 20120061039 A | 12-06-2012 |
| | | | US | 2012037805 A1 | 16-02-2012 |
| | | | WO | 2010125281 A1 | 04-11-2010 |

EPO FORM P0460

Pour tout renseignement concernant cette annexe : voir Journal Officiel de l'Office européen des brevets, No.12/82

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 2208976 A1